# EUROPEAN PATENT APPLICATION

(11) **EP 2 437 320 A2**
(43) Date of publication of application: **04.04.2012**
(21) Application number: 11183087.3
(22) Date of filing: 28.09.2011
(51) Int. Cl.: H01L 33/54, H01L 33/58

(54) **Light emitting diode sealing member and method for producing light emitting diode device**

(30) Priority: 30.09.2010 JP 2010221681; 10.08.2011 JP 2011174617
(71) Applicant: NITTO DENKO CORPORATION, Ibaraki-shi, Osaka 567-8680 (JP)
(72) Inventor: Shinbori, Yuki, Osaka, 567-8680 (JP); Ooyabu, Yasunari, Osaka, 567-8680 (JP); Sato, Satoshi, Osaka, 567-8680 (JP); Ito, Hisataka, Osaka, 567-8680 (JP)
(74) Representative: HOFFMANN EITLE

(57) **Abstract**

A light emitting diode sealing member includes a light emitting diode sealing layer, and a lens mold layer laminated on the light emitting diode sealing layer.

## Description

### BACKGROUND OF THE INVENTION

### Field of the Invention

The present invention relates to a light emitting diode sealing member and a method for producing a light emitting diode device using the light emitting diode sealing member.

### Description of Related Art

In recent years, white light emitting devices are known as light emitting devices capable of emitting high energy light. A white light emitting device is provided with, for example, an LED (light emitting diode) which emits blue light, and a phosphor layer which can convert blue light into yellow light and covers the LED. The white light emitting device emits white light of high energy by mixing the blue light emitted from the LED and the yellow light into which the blue light has been converted through the phosphor layer.

As such light emitting device, for example, an illuminating light source has been proposed which includes a printed-wiring board provided with a reflection frame; a plurality of blue semiconductor light emitting elements mounted in the reflection frame of the board; a transparent resin filled in the reflection frame, having a phosphor which absorbs blue light from the semiconductor light emitting elements and then emits yellow light, dispersed; and a transparent resin in a convex lens-like shape laminated on the resin, having the above phosphor dispersed (cf. Japanese Unexamined Patent Publication No. 2001-148514 (FIG. 7)).

### SUMMARY OF THE INVENTION

To produce the illuminating light source disclosed in Japanese Unexamined Patent Publication No. 2001-148514, the following steps are performed: First, a semiconductor light emitting element is mounted on a printed-wiring board provided with a reflection frame, and the inside of the reflection frame is sealed with a resin. Subsequently, a resin separately formed in a convex lens-like shape is laminated on the sealing resin. This requires many process steps and also requires positioning accuracy of a lens, leading to an increase in production cost.

It is an object of the present invention to provide a light emitting diode sealing member which allows a light emitting diode device to be produced easily and accurately in fewer process steps, and a method for producing the light emitting diode device using the light emitting diode sealing member.

The light emitting diode sealing member of the present invention includes a light emitting diode sealing layer; and a lens mold layer laminated on the light emitting diode sealing layer.

The light emitting diode sealing member allows a light emitting diode to be sealed with the light emitting diode sealing layer and also enables a lens to be formed with the lens mold layer. That is, the light emitting diode sealing member eliminates the need for disposing a lens after a light emitting diode is sealed, so that the light emitting diode device can be produced easily and accurately in fewer process steps.

In the light emitting diode sealing member of the present invention, it is preferable that the light emitting diode sealing layer is made of silicone resin containing a phosphor.

Since the light emitting diode sealing layer is made of silicone resin, the light emitting diode sealing member can ensure excellent light resistance and heat resistance. Furthermore, since the silicone resin contains a phosphor, the light emitting diode sealing layer can efficiently fluoresce.

In the light emitting diode sealing member of the present invention, it is preferable that the lens mold layer is made of silicone resin.

Since the lens mold layer is made of silicone resin, the light emitting diode sealing member can ensure excellent light resistance and heat resistance.

It is preferable that the light emitting diode sealing member of the present invention further includes a deformation preventing layer between the light emitting diode sealing layer and the lens mold layer.

When a light emitting diode is sealed by, for example, compression molding or the like using the light emitting diode sealing member, the light emitting diode sealing layer and/or the lens mold layer may be deformed. However, since the light emitting diode sealing member has the deformation preventing layer laminated between the light emitting diode sealing layer and the lens mold layer, deformation of the light emitting diode sealing layer and the lens mold layer can be suppressed.
In the light emitting diode sealing member of the present invention, it is preferable that both of the light emitting diode sealing layer and the lens mold layer are made of a silicone resin curable with a curing catalyst, the light emitting diode sealing layer containing more curing catalysts than the lens mold layer does.
During curing of the light emitting diode sealing member, the light emitting diode sealing layer containing more curing catalysts is cured earlier than the lens mold layer. Therefore, with the light emitting diode sealing member, deformation of the light emitting diode sealing layer and the lens mold layer can be suppressed during sealing of a light emitting diode.

The method for producing a light emitting diode device according to the present invention includes the steps of preparing a substrate having a light emitting diode mounted thereon; preparing a lens molding die; and arranging the above-mentioned light emitting diode sealing member between the substrate and the lens molding die so that the lens mold layer is opposed to the lens molding die, and then compression molding the light emitting diode sealing member.

According to the method for producing the light emitting diode device, the use of the above-mentioned light emitting diode sealing member allows the light emitting diode sealing layer to seal the light emitting diode by compression molding, and at the same time, allows the lens mold layer to mold a lens. That is, there is no need for disposing a lens after the light emitting diode is sealed, so that the light emitting diode device can be produced easily and accurately in fewer process steps.

### BRIEF DESCRIPTION OF THE DRAWINGS

FIG. 1 is a schematic configurational diagram illustrating a light emitting diode sealing member according to an embodiment of the invention;
FIG. 2 is a process diagram illustrating a method for producing a light emitting diode device according to an embodiment of the invention,
   (a) showing the step of preparing a substrate having a light emitting diode mounted thereon,
   (b) showing the step of preparing a lens molding die, and
   (c) showing the step of arranging a light emitting diode sealing member between the substrate and the lens molding die so that a lens mold layer is opposed to the lens molding die;

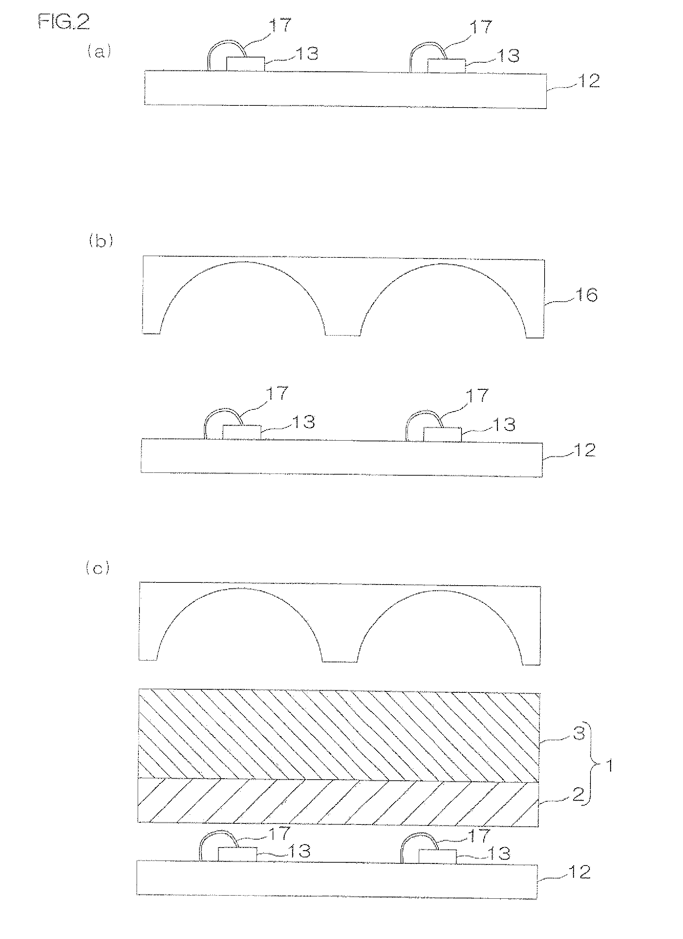

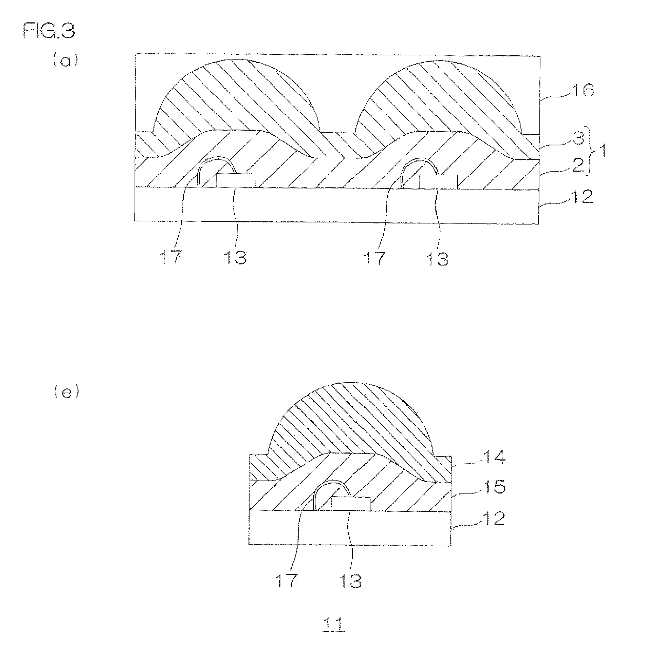

FIG. 3 is a process diagram illustrating the method for producing the light emitting diode device according to an embodiment of the invention, subsequent to FIG. 2,
   (d) showing the step of compression molding the light emitting diode sealing member,
      and
   (e) showing the step of removing the lens molding die and cutting the molded product into separate pieces;

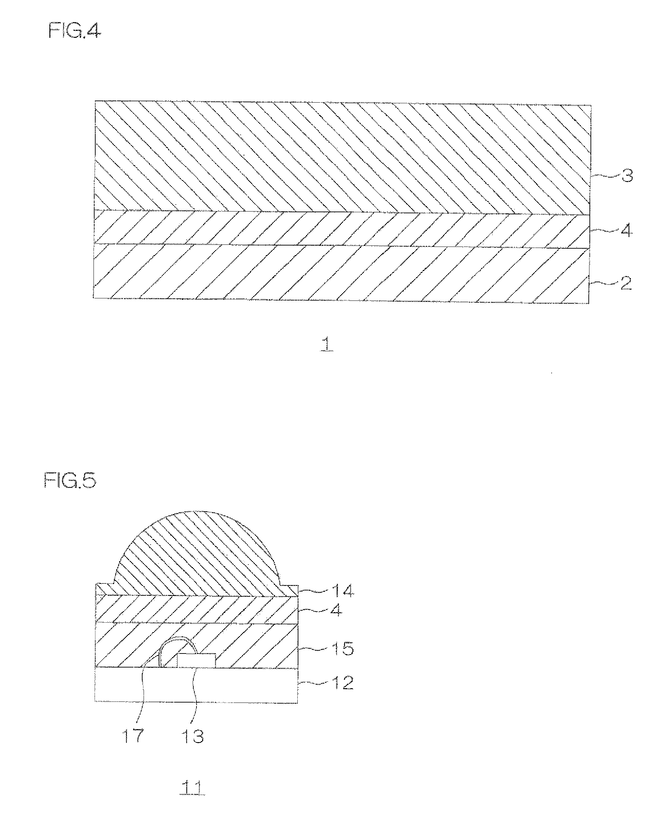

FIG. 4 is a schematic configurational diagram illustrating a light emitting diode sealing member according to another embodiment (an embodiment provided with a deformation preventing layer) of the invention;
FIG. 5 is a schematic configurational diagram illustrating a light emitting diode device using the light emitting diode sealing member shown in FIG. 4;

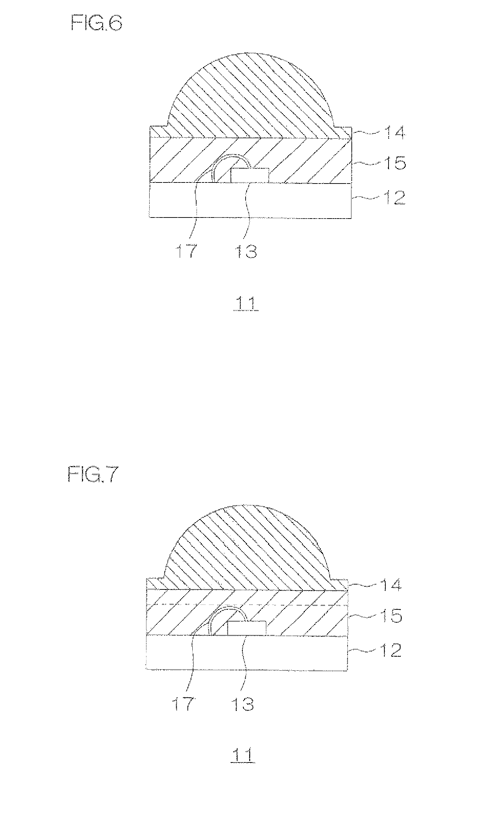

FIG. 6 is a schematic configurational diagram illustrating a light emitting diode device using a light emitting diode sealing member according to another embodiment (an embodiment in which, in the light emitting diode sealing member, a light emitting diode sealing layer contains more curing catalysts than a lens mold layer does) of the invention; and
FIG. 7 is a schematic configurational diagram illustrating a light emitting diode device using a light emitting diode sealing member according to another embodiment (an embodiment in which, in the light emitting diode sealing member, a light emitting diode sealing layer is formed in a double-layer structure) of the invention.

### DETAILED DESCRIPTION OF PREFERRED EMBODIMENTS

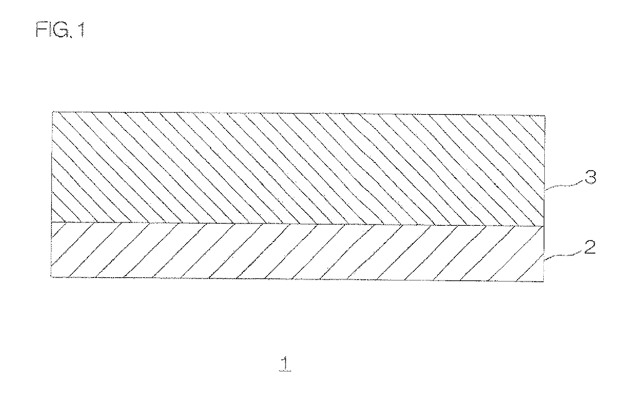

FIG. 1 is a schematic configurational diagram illustrating a light emitting diode sealing member according to an embodiment of the invention.

In FIG. 1, the light emitting diode sealing member 1 includes a light emitting diode sealing layer 2 and a lens mold layer 3.

The light emitting diode sealing layer 2 is a resin layer provided to seal a light emitting diode 13 (described later) in a light emitting diode device 11 (described later), and is formed, for example, in a generally rectangular flat plate in plan view made of resin capable of transmitting light.

Examples of the resin include known transparent resins such as a silicone resin, an epoxy resin, and an acrylic resin. These resins can be used alone or in combination of two or more kinds.

Of these resins, a silicone resin is preferable.

The use of a silicone resin as the resin can ensure excellent light resistance and heat resistance.

As the silicone resin, for example, a thermosetting silicone resin may be used. As such thermosetting silicone resin, for example, a silicone resin composition which can be subjected to a condensation reaction and an addition reaction (specifically a hydrosilylation reaction) may be used.

The silicone resin composition is a composition which can be formed in a B-stage state (semi-cured state) by a condensation reaction with heating, and can then be formed in a cured (completely cured) state by an addition reaction with further heating.

It should be noted that a resin composition in the B-stage state refers to a resin composition in a state between an A stage where a resin is soluble in a solvent and a C stage where a resin is completely cured, and in a state where curing or gelation somewhat proceeds, and the resin is swelled but is not completely dissolved in a solvent, and is softened but is not melted by heating.

The silicone resin composition contains, for example, a polysiloxane having silanol groups at both ends, an alkenyl group-containing alkoxysilane, and an organohydrogensiloxane. The polysiloxane having silanol groups at both ends and the alkenyl group-containing alkoxysilane are condensation raw materials (raw materials subjected to a condensation reaction), and the organohydrogensiloxane is an addition raw material (raw material subjected to an addition reaction).

The polysiloxane having silanol groups at both ends is a silane compound which contains a silanol group (SiOH group) at both ends of a molecule, and is specifically represented by the following formula (1):

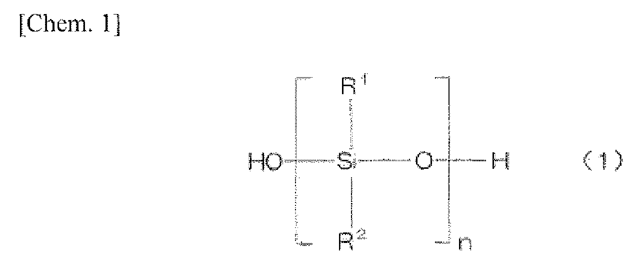

(in the formula (1), R1 and R2 each represents a monovalent hydrocarbon, n represents an integer of 1 or more, and R1 and R2 may be the same or different from each other.)

In the above formula (1), R1 and R2 may be preferably the same.

Examples of the monovalent hydrocarbon group represented by R1 and R2 include saturated or unsaturated, linear, branched, or cyclic hydrocarbon groups. The carbon number of the hydrocarbon group is, for example, from 1 to 20, or preferably from 1 to 10, from the viewpoint of ease of preparation or thermal stability.

Specific examples of the monovalent hydrocarbon group include saturated aliphatic hydrocarbon groups such as methyl, ethyl, propyl, isopropyl, butyl, isobutyl, pentyl, cyclopentyl, hexyl, and cyclohexyl; and aromatic hydrocarbon groups such as phenyl and naphthyl.

Of these monovalent hydrocarbon groups, a saturated aliphatic hydrocarbon group is preferable, or methyl is more preferable, from the viewpoints of transparency and light resistance.

In the above formula (1), n is preferably an integer of 1 to 10000, or more preferably an integer of 1 to 1000, from the viewpoints of stability and/or handleability.

Specific examples of the polysiloxane having silanol groups at both ends include polydimethylsiloxane having silanol groups at both ends, polymethylphenylsiloxane having silanol groups at both ends, and polydiphenylsiloxane having silanol groups at both ends. Of these, polydimethylsiloxane having silanol groups at both ends is preferable.

Commercially available polysiloxane having silanol groups at both ends can be used, and those synthesized according to known methods can also be used.

These polysiloxanes having silanol groups at both ends can be used alone or in combination of two or more kinds.

The polysiloxane having silanol groups at both ends is usually a mixture of compounds having different n (i.e., different molecular weights).

Therefore, n in the above formula (1) is calculated as an average value.

The polysiloxane having silanol groups at both ends has a number average molecular weight of, for example, 100 to 1,000,000, or preferably 200 to 100,000, from the viewpoints of stability and/or handleability. The number average molecular weight is determined in terms of standard polystyrene by gel permeation chromatography. The number average molecular weight to be described later is also calculated in the same manner as above.

The blended amount of the polysiloxane having silanol groups at both ends is in the range of, for example, 1 to 99.99% by mass, preferably 50 to 99.9% by mass, or more preferably 80 to 99.5% by mass, of the total amount of the condensation raw materials.

The alkenyl group-containing alkoxysilane is a silane compound having both an alkenyl group and an alkoxy group, and is specifically an alkenyl group-containing trialkoxysilane represented by the following formula (2):

R³-Si(OR⁴)₃ (2)

(in the formula (2), R3 is a linear or cyclic alkenyl group, and R4 is a monovalent hydrocarbon group. R3 and R4 are different from each other.)

The carbon number of the alkenyl group represented by R3 is, for example, from 1 to 20, or preferably from 1 to 10, from the viewpoint of ease of preparation or thermal stability.

Specific examples of the alkenyl group include linear alkenyl groups such as a vinyl group, an allyl group, a propenyl group, a butenyl group, a pentenyl group, a hexenyl group, a heptenyl group, and an octenyl group; and cyclic alkenyl groups such as a norbornenyl group and a cyclohexenyl group.

Of these, a linear alkenyl group is preferable, or from the viewpoint of the reactivity of the addition reaction, a vinyl group is more preferable.

Examples of the monovalent hydrocarbon group represented by R4 include the same monovalent hydrocarbon groups as those represented by R1 and R2 in the above formula (1). Of these, methyl is preferable.

Specific examples of the alkenyl group-containing alkoxysilane include vinyltrialkoxysilane such as vinyltrimetoxysilane, vinyltriethoxysilane, and vinyltripropoxysilane; allyltrimethoxysilane; propenyltrimethoxysilane; butenyltrimethoxysilane; pentenyltrimethoxysilane; hexenyltrimethoxysilane; heptenyltrimethoxysilane; octenyltrimethoxysilane; norbornenyltrimethoxysilane; and cyclohexenyltrimethoxysilane.

Of these, vinyltrialkoxysilane is preferable, or vinyltrimetoxysilane is more preferable.

These alkenyl group-containing alkoxysilanes can be used alone or in combination of two or more kinds.

Commercially available alkenyl group-containing alkoxysilanes can be used, and those synthesized according to known methods can also be used.

The blended amount of the alkenyl group-containing alkoxysilane is in the range of, for example, 0.01 to 90% by mass, preferably 0.01 to 50% by mass, or more preferably 0.01 to 10% by mass, of the total amount of the condensation raw materials.

The molar ratio (SiOH/SiOR⁴) of the silanol group (SiOH group) of the polysiloxane having silanol groups at both ends to the alkoxysilyl group (SiOR⁴ group) of the alkenyl group-containing alkoxysilane is in the range of, for example, 20/1 to 0.2/1, preferably 10/1 to 0.5/1, or more preferably substantially 1/1.

When the molar ratio exceeds the above range, a B-staged material (a semi-cured material) having moderate toughness may not be obtained in the case of forming the silicone resin composition in the B-stage state. On the other hand, when the molar ratio is less than the above range, the blended amount of the alkenyl group-containing alkoxysilane is excessively high, which may result in poor heat resistance of the obtained resin layer (light emitting diode sealing layer 2).

Further, when the molar ratio is within the above range (preferably substantially 1/1), the silanol group (SiOH group) of the polysiloxane having silanol groups at both ends and the alkoxysilyl group (SiOR⁴ group) of the alkenyl group-containing alkoxysilane can be subjected to condensation reaction in a proper quantity.

The organohydrogensiloxane is a compound containing a hydrogen atom directly bonded to a silicon atom in a main chain, and examples thereof include a hydride compound containing a hydrogen atom directly bonded to a silicon atom in the middle (between both ends) of the main chain, which is represented by the following formula (3); or a hydride compound (polysiloxane having hydrosilyl groups at both ends) containing a hydrogen atom directly bonded to silicon atoms at both ends of the main chain, which is represented by the following formula (4):

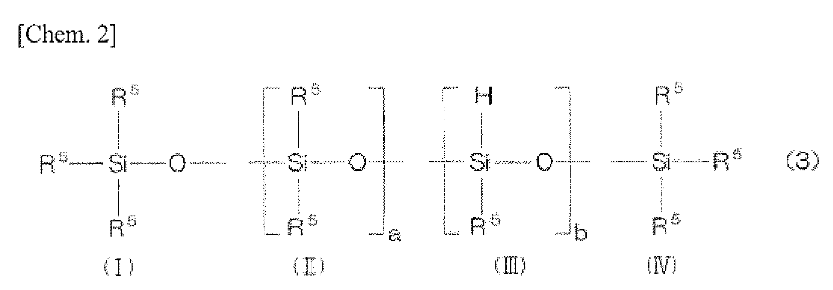

(in the formula (3), I, II, III, and IV are constitutional units, I and IV each represents a terminal unit, II and III each represents a repeating unit, all of R5 may be the same or different from each other, and each represents a monovalent hydrocarbon group. a represents an integer of 0 or 1 or more, and b represents an integer of 2 or more.)

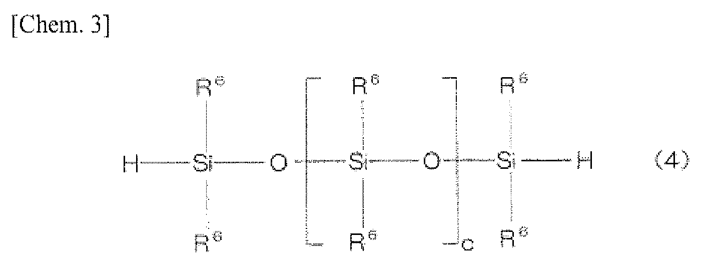

(in the formula (4), all of R6 may be the same or different from each other and each represents a monovalent hydrocarbon group. c represents an integer of 0 or 1 or more.)

R5 in constitutional unit I, R5 in constitutional unit II, R5 in constitutional unit III, and R5 in constitutional unit IV may be preferably the same.

Examples of the monovalent hydrocarbon group represented by R5 include the same monovalent hydrocarbon groups as those represented by R1 and R2 described above. Of these, a saturated aliphatic hydrocarbon group is preferable, methyl and ethyl are more preferable, or methyl is even more preferable.

Constitutional units I and IV each represents a terminal unit at each end.

a in constitutional unit II represents the number of repeating units of constitutional unit II, and represents preferably an integer of 1 to 1000, or more preferably an integer of 1 to 100, from the viewpoint of reactivity.

b in constitutional unit III represents the number of repeating units of constitutional unit III, and represents preferably an integer of 2 to 10000, or more preferably an integer of 2 to 1000, from the viewpoint of reactivity.

Specific examples of the hydride compound represented by the above formula (3) include a methylhydrogenpolysiloxane, a dimethylpolysiloxane-co-methylhydrogenpolysiloxane, an ethylhydrogenpolysiloxane, and a methylhydrogenpolysiloxane-co-methylphenylpolysiloxane. Of these, a dimethylpolysiloxane-co-methylhydrogenpolysiloxane is preferable.

These hydride compounds represented by the above formula (3) can be used alone or in combination of two or more kinds.

The hydride compound represented by the above formula (3) is usually a mixture of compounds having different a and/or b (i.e., different molecular weights).

Therefore, a in constitutional unit II and b in constitutional unit III are each calculated as an average value.

The hydride compound represented by the above formula (3) has a number average molecular weight of, for example, 100 to 1,000,000.

All of R6 in the above formula (4) may be preferably the same. That is, R6 bonded to the silicon atoms at both ends and R6 bonded to the silicon atom between both ends are all the same.

Examples of the monovalent hydrocarbon group represented by R6 include the same monovalent hydrocarbon groups as those represented by R1 and R2 described above. Of these, methyl and ethyl are preferable.

In the above formula (4), c represents preferably an integer of 1 to 10,000, or more preferably an integer of 1 to 1,000, from the viewpoint of reactivity.

Specific examples of the hydride compound represented by the above formula (4) include (polysiloxane having hydrosilyl groups at both ends, polymethylphenylsiloxane having hydrosilyl groups at both ends, and polydiphenylsiloxane having hydrosilyl groups at both ends.

These hydride compounds represented by the above formula (4) can be used alone or in combination of two or more kinds.

The hydride compound represented by the above formula (4) is usually a mixture of compounds having different c (i.e., different molecular weights).

Therefore, c in the above formula (4) is calculated as an average value.

The hydride compound represented by the above formula (4) has a number average molecular weight of, for example, 100 to 1,000,000, or more preferably 100 to 100,000, from the viewpoints of stability and/or handleability.

The organohydrogensiloxane has a viscosity at 25°C of, for example, 10 to 100,000 mPa·s, or preferably 20 to 50,000 mPa·s. The viscosity can be measured with a B type viscometer.

Commercially available organohydrogensiloxane can be used, and those synthesized according to known methods can also be used.

As the organohydrogensiloxane, the hydride compound represented by the above formula (3) or the hydride compound represented by the above formula (4) can be used alone or in combination. Preferably, the hydride compound represented by the above formula (3) is used alone as the organohydrogensiloxane.

The blended amount of the organohydrogensiloxane is in the range of, for example, 10 to 10,000 parts by mass, or preferably 50 to 1,000 parts by mass, per 100 parts by mass of the alkenyl group-containing alkoxysilane, depending upon the molar ratio of the alkenyl group (R³ in the above formula (2)) of the alkenyl group-containing alkoxysilane to the hydrosilyl group (SiH group) of the organohydrogensiloxane.

The molar ratio (R³/SiH) of the alkenyl group (R³ in the above formula (2)) of the alkenyl group-containing alkoxysilane to the hydrosilyl group (SiH group) of the organohydrogensiloxane is, in the range of, for example, 20/1 to 0.05/1, preferably 20/1 to 0.1/1, more preferably 10/1 to 0.1/1, even more preferably 5/1 to 0.2/1, or most preferably substantially 1/1.

When the molar ratio exceeds 20/1, a semi-cured material having moderate toughness may not be obtained in the case of forming the silicone resin composition in the B-stage state. On the other hand, when the molar ratio is less than 0.05/1, the blended amount of the organohydrogensiloxane is excessively high, which may result in poor heat resistance and toughness of the obtained resin layer (light emitting diode sealing layer 2).

Further, when the molar ratio is less than 1/1 and 0.05/1 or more, the silicone resin composition can be shifted to the B-stage state more quickly than a silicone resin composition having a molar ratio of 20/1 to 1/1 in the case of forming the silicone resin composition in the B-stage state.

The silicone resin composition is prepared by blending the above-mentioned polysiloxane having silanol groups at both ends, alkenyl group-containing alkoxysilane, and organohydrogensiloxane with a catalyst, and then mixing them with stirring.

Examples of the catalyst include a condensation catalyst (semi-curing catalyst)_and an addition reaction catalyst (curing catalyst and hydrosilylation catalyst).

There is no particular limitation on the condensation catalyst, as long as it is a compound which can increase the reaction rate of the condensation reaction between the silanol group and the alkoxysilyl group, and examples thereof include acids such as hydrochloric acid, acetic acid, formic acid, and sulfuric acid; bases such as potassium hydroxide, sodium hydroxide, potassium carbonate, and tetramethylammonium hydroxide; and metal catalysts such as aluminum, titanium, zinc, and tin.

Of these, bases are preferable, or tetramethylammonium hydroxide is more preferable, from the viewpoints of compatibility and thermal decomposition characteristics.

The blended amount of the condensation catalyst is in the range of, for example, from 0.1 to 50 moles, or preferably from 0.5 to 5 moles, per 100 moles of the polysiloxane having silanol groups at both ends.

There is no particular limitation on the addition reaction catalyst, as long as it is a compound which can increase the reaction rate of the addition reaction, i.e., a hydrosilylation reaction between an alkenyl group and SiH, and examples thereof include platinum catalysts such as platinum black, platinum chloride, chloroplatinic acid, a platinum-olefin complex, a platinum-carbonyl complex, and platinum-acetyl acetate; and metal catalysts such as palladium catalyst and rhodium catalyst.

Of these, platinum catalysts are preferable, or a platinum-carbonyl complex is more preferable, from the viewpoints of compatibility, transparency, and catalytic activity.

The blended amount of the addition reaction catalyst is in the range of, for example, 1.0x10⁻⁴ to 1.0 part by mass, preferably 1.0x10⁻⁴ to 0.5 parts by mass, or more preferably 1.0x10⁻⁴ to 0.05 parts by mass, per 100 parts by mass of the organohydrogensiloxane, in terms of the amount of metal in the addition reaction catalyst.

The above-mentioned catalyst may be used as in a solid state or can be used in the form of a solution or dispersion dissolved or dispersed in a solvent, from the viewpoint of handleability.

Examples of the solvent include water; and alcohols such as methanol, ethanol, 1-propanol, and 2-propanol. Of these, water is preferable.

To prepare the silicone resin composition, for example, the above-mentioned raw materials (the condensation raw material and the addition raw material) and the catalysts are added at once. Alternatively, the raw materials and the catalysts can be first added at different timings. In another alternative process, some components can be added at once and the remaining components can also be added at different timings.

Preferably, the condensation catalyst is first added to the condensation raw material, and the addition raw material and the addition reaction catalyst are then added at once.

Specifically, the condensation catalyst is blended with the polysiloxane having silanol groups at both ends and the alkenyl group-containing alkoxysilane (i.e., condensation raw materials) at the above proportion, and the mixture is stirred for, for example, 5 minutes to 24 hours.

The temperature for blending and stirring can be set to, for example, 0 to 60°C in order to improve the compatibility and handleability of the condensation raw materials.

In addition, a compatibilizer can be added in an appropriate proportion during blending of the raw materials and the condensation catalyst in order to improve their compatibility.

Examples of the compatibilizer include organic solvents such as alcohols including methanol, ethanol, 1-propanol, and 2-propanol. In addition, when the condensation catalyst is prepared as a solution or a dispersion of an organic solvent, the organic solvent can be applied as a compatibilizer.

The blended amount of the compatibilizer is in the range of, for example, 1 to 20 parts by mass, or preferably 5 to 10 parts by mass, per 100 parts by mass of the total amount of the polysiloxane having silanol groups at both ends and the alkenyl group-containing alkoxysilane.

Thereafter, the reaction system (mixture) is depressurized as required, to thereby remove a volatile component (organic solvent).

Next, an organohydrogensiloxane and an addition reaction catalyst are blended with thus obtained mixture of the condensation raw material and the condensation catalyst, and the blended mixture is stirred for, for example, 1 to 60 minutes.

The temperature for blending and stirring can be set to, for example, 0 to 60°C in order to improve the compatibility and handleability of the mixture and the organohydrogensiloxane.

Thus, the silicone resin composition can be prepared.

In the light emitting diode sealing layer 2, a resin or preferably a silicone resin can contain a phosphor.

Examples of the phosphor include a yellow phosphor capable of converting blue light into yellow light. As such phosphor, phosphors having composite metal oxide or metal sulfide doped with metal atoms such as cerium (Ce) and europium (Eu) may be used.

Specific examples of the phosphor include garnet type phosphors having garnet crystal structure such as Y₃Al₅O₁₂: Ce (YAG(yttrium aluminum garnet):Ce), (Y, Gd)₃Al₅O₁₂:Ce, Tb₃Al₃O₁₂:Ce, Ca₃Sc₂Si₃O₁₂:Ce, and Lu₂CaMg₂(Si, Ge)₃O₁₂:Ce; silicate phosphors such as (Sr, Ba)₂SiO₄:Eu, Ca₃SiO₄Cl₂:Eu, Sr₃SiO₅:Eu, Li₂SrSiO₄:Eu, and Ca₃Si₂O₇:Eu; aluminate phosphors such as CaAl₁₂O₁₉:Mn and SrAl₂O₄:Eu; sulfide phosphors such as ZnS:Cu,Al, CaS:Eu, CaGa₂S₄:Eu, and SrGa₂S₄:Eu; oxynitride phosphors such as CaSi₂O₂N₂:Eu, SrSi₂O₂N₂:Eu, BaSi₂O₂N₂:Eu, and Ca-α-SiAlON; nitride phosphors such as CaAlSiN₃:Eu and CaSi₅N₈:Eu; and fluoride phosphors such as K₂SiF₆:Mn and K₂TiF₆:Mn. Of these, garnet type phosphors are preferable, or Y₃Al₅O₁₂:Ce is more preferable.

The phosphor is in a particulate form and the shape thereof is not particularly limited. Examples thereof include a generally spherical shape, a generally planar shape, and a generally needle-like shape.

The phosphor has an average particle size (average of the maximum length) of, for example, 0.1 to 30 µm, or preferably 0.2 to 20 µm. The average particle size of the phosphor particle is measured with a size distribution measuring device.

These phosphors can be used alone or in combination.

When the resin which forms the light emitting diode sealing layer 2 contains a phosphor, the phosphor can efficiently fluoresce in the light emitting diode sealing layer 2.

For example, in the light emitting diode device 11 (described later), using a blue light-emitting diode or the like as the light emitting diode 13 (described later), a light produced from the light emitting diode 13 (described later) and a light produced from a phosphor are blended, so that the light emitting diode device 11 (described later) can be used as, for example, the light emitting diode device 11 (white light emitting diode) that produces white light.

The phosphor is contained in a proportion of, for example, 1 to 50 parts by mass, or 3 to 30 parts by mass, per 100 parts by mass of the resin (preferably silicone resin).

In order to contain the phosphor in the resin, the above-mentioned phosphor and the resin are blended, and the mixture is mixed with stirring. The stirring time is, for example, 0.5 to 2 hours.

The resin can contain an inorganic particle as required.

The resin containing an inorganic particle can reduce the curing shrinkage ratio during curing of the resin, so that a crack or a precise shape and size of a part can be reproduced as designed. Further, heat resistance or thermal conductivity can be improved.

Examples of the inorganic particle include glass, alumina, aluminum hydroxide, silica (fused silica, crystalline silica, superfine amorphous silica, hydrophobic superfine silica, etc.), talc, clay, and barium sulfate.

These inorganic particles can be used alone or in combination of two or more kinds.

Of these, silica is preferable.

The particle size of the inorganic particle is variously selected depending on the purpose and application, and the maximum particle size thereof is preferably 50 nm or less, or more preferably 20 nm or less, from the viewpoint of transparency. More specific examples of the inorganic particle include nano silica (nano particle silica).

The inorganic particle is contained in a proportion of, for example, 1 to 50 parts by mass, or 3 to 30 parts by mass, per 100 parts by mass of the resin (preferably silicone resin).

When the resin contains a phosphor and an inorganic particle, the phosphor is contained in a proportion of, for example, 10 to 50 parts by mass, or preferably 30 to 40 parts by mass, and the inorganic particle is contained in a proportion of, for example, 50 to 90 parts by mass, or preferably 60 to 70 parts by mass, of 100 parts by mass of the total amount of the phosphor and the inorganic particle.

Further, known additives such as a transmission inhibitor, a modifying agent, a surfactant, a dye, a pigment, a discoloration preventing agent, and an ultraviolet absorber can be added to the resin in an appropriate proportion.

The light emitting diode sealing layer 2 can be produced, for example, in a B-stage state by coating the above-mentioned resin to a known release paper and then heating the coated resin.

As the heating conditions, in the case where the resin is composed of silicone resin composition, a condensation reaction proceeds but an addition reaction (hydrosilylation reaction) does not proceed. Specifically, the heating temperature is in the range of, for example, 40 to 150°C, or preferably 50 to 140°C, and the heating time is in the range of, for example, 1 to 60 minutes, or preferably 3 to 30 minutes.

The light emitting diode sealing layer 2 has a thickness of, for example, 100 to 1000 µm, or preferably 300 to 500 µm.

The lens mold layer 3 is a resin layer provided in the light emitting diode device 11 (described later) in order to be molded to a lens 14 (described later), and is formed, for example, in a generally rectangular flat plate in plan view made of resin capable of transmitting light.

Examples of the resin include the same resins as used for the above-mentioned light emitting diode sealing layer 2, and specifically include known transparent resins such as a silicone resin, an epoxy resin, and an acrylic resin. These resins can be used alone or in combination of two or more kinds.

Of these resins, the same silicone resin as used for the light emitting diode sealing layer 2 is preferable.

The use of a silicone resin as the resin can ensure excellent light resistance and heat resistance.

In the lens mold layer 3, the resin can contain an inorganic particle and a known additive as described above except a phosphor.

The lens mold layer 3 can be produced, for example, in a B-stage state by coating the above-mentioned resin to a known release paper and then heating the coated resin.

As the heating conditions, in the case where the resin is composed of silicone resin composition, a condensation reaction proceeds but an addition reaction (hydrosilylation reaction) does not proceed. Specifically, the heating temperature is in the range of, for example, 40 to 150°C, or preferably 50 to 140°C, and the heating time is in the range of, for example, 1 to 60 minutes, or preferably 3 to 30 minutes.

The lens mold layer 3 has a thickness of, for example, 100 to 1200 µm, or preferably 600 to 900 µm.

The lens mold layer 3 is, for example, 1 to 3 times thicker than the light emitting diode sealing layer 2.

The light emitting diode sealing layer 2 and the lens mold layer 3 are then stuck to each other, and the stuck layers are heated at, for example, 40 to 150°C, or preferably 50 to 140°C for 1 to 60 minutes, or preferably 3 to 30 minutes, so that the light emitting diode sealing member 1 can be produced with the light emitting diode sealing layer 2 and the lens mold layer 3 being kept in the B-stage state.

The light emitting diode sealing member 1 has a thickness of, for example, 200 to 2200 µm, or preferably 1000 to 1500 µm.

Although the details will be described later, according to the light emitting diode sealing member 1, since the light emitting diode 13 (described later) is sealed with the light emitting diode sealing layer 2 and the lens 14 (described later) can be molded with the lens mold layer 3, the light emitting diode device 11 (described later) can be produced easily and accurately in fewer process steps.

Next, a method for producing a light emitting diode device according to an embodiment of the invention is described with reference to FIGS. 2 and 3. The same reference numerals are provided in each of the subsequent figures for members corresponding to each of those described above, and their detailed description is omitted.

In this method, a substrate 12 having a light emitting diode 13 mounted thereon is first prepared, as shown in FIG. 2(a).

The substrate 12 is formed from, for example, a lead frame made of silver-plated copper.

Wirings for electrically connecting between a terminal of the light emitting diode 13 and a terminal (not shown) of a power source for supplying electricity to the light emitting diode 13 are formed on the upper surface of the substrate 12, though not shown.

As the light emitting diode 13, for example, a blue light-emitting diode (blue LED) which emits blue light may be primarily used.

A plurality (two appeared in FIGS. 2 and 3) of light emitting diodes 13 are installed on the upper surface of the substrate 12 and are electrically connected (wire bonded) to the wirings (not shown) through wires 17.

Next, in this method, as shown in FIG. 2(b), a lens molding die 16 is prepared.

The lens molding die 16 is a molding die made of, for example, hard chromium-plated stainless steel and has a plurality (two appeared in FIGS. 2 and 3) of shapes corresponding to the lenses 14 (described later), for example, hemispherical recesses, to correspond to the light emitting diodes 13.

Next, in this method, as shown in FIG. 2(c), the light emitting diode sealing member 1 (see FIG. 1) in the B-stage state as described above is arranged between the substrate 12 and the lens molding die 16 so that the lens mold layer 3 is opposed to the lens molding die 16. As shown in FIG. 3(d), the light emitting diode sealing member 1 is compression molded so as to be sandwiched between the substrate 12 and the lens molding die 16, and the lens molding die 16 is then removed.

Practically, after the light emitting diode sealing member 1 is placed on the lens molding die 16 (on the recess-formed side), the substrate 12 provided with the light emitting diodes 13 is placed thereon so that the light emitting diodes 13 are opposed to the light emitting diode sealing member 1, and compression molding is then performed.

For the compression molding, the compression pressure is in the range of, for example, 0.1 to 5 MPa, or preferably 0.5 to 3 MPa, and the compression time is in the range of, for example, 1 to 10 minutes, or preferably 2 to 6 minutes.

This forms the outer shape of the lens mold layer 3 into a shape corresponding to the lens molding die 16 while the light emitting diodes 13 are sealed with the light emitting diode sealing layer 2.

For example, when the light emitting diode sealing member 1 is in the B-stage state, the light emitting diode sealing member 1 can be compression molded and also be subjected to heat treatment.

The heat treatment is usually performed in two steps: a first step of curing the light emitting diode sealing member 1 to the extent that the light emitting diode sealing layer 2 and the lens mold layer 3 can be released from the mold; and a second step of completely curing the light emitting diode sealing member 1 after the mold release from the lens molding die 16.

That is, when the light emitting diode sealing layer 2 and the lens mold layer 3 are both formed of a silicone resin composition, an addition reaction (hydrosilylation reaction) proceeds. Specifically, as the heating conditions, the first step is performed, for example, at a temperature of 120 to 180°C for 2 to 20 minutes, and the second step is performed, for example, at a temperature of 100 to 180°C for 30 minutes to 5 hours.

Thus, the compression molding (and the heat treatment as required) can cure the light emitting diode sealing member 1 in a state where the light emitting diode sealing layer 2 seals the light emitting diodes 13 and in a shape of which the lens mold layer 3 corresponds to the lens molding die 16. This can form a sealing layer 15 (light emitting diode sealing layer 2 after curing) and the lenses 14 (lens mold layer 3 after curing) simultaneously.

Thereafter, as shown in FIG. 3(e), the light emitting diodes 13 are cut into separate pieces so as to be individualized, as required. Thus, the light emitting diode device 11 can be produced.

According to the method for producing the light emitting diode device 11, since the above-mentioned light emitting diode sealing member 1 is used, compression molding allows the light emitting diodes 13 to be sealed with the light emitting diode sealing layer 2 and, at the same time, it allows the lenses 14 to be formed with the lens mold layer 3. That is, it is not necessary to dispose the lenses 14 after the light emitting diodes 13 are sealed, so that the light emitting diode device 11 can be produced easily and accurately in fewer process steps.

FIG. 4 is a schematic configurational diagram illustrating a light emitting diode sealing member according to another embodiment (an embodiment provided with a deformation preventing layer) of the invention.

In the above description, the lens mold layer 3 is directly laminated on one side surface of the light emitting diode sealing layer 2. However, for example, a deformation preventing layer can further be provided between the light emitting diode sealing layer 2 and the lens mold layer 3.

In FIG. 4, the light emitting diode sealing member 1 includes the light emitting diode sealing layer 2, the lens mold layer 3, and the deformation preventing layer 4.

The deformation preventing layer 4 is a resin layer provided in the light emitting diode device 11 (described later) in order to prevent deformation of the light emitting diode sealing layer 2 (including the sealing layer 15 described later) and the lens mold layer 3 (including the lenses 14 described later), and is formed, for example, in a generally rectangular flat plate in plan view made of resin capable of transmitting light.

Examples of the resin include the same resins as used for the above-mentioned light emitting diode sealing layer 2, and specifically include known transparent resins such as a silicone resin, an epoxy resin, and an acrylic resin. These resins can be used alone or in combination of two or more kinds.

Of these resins, a silicone resin is preferable, and a liquid silicone rubber is more preferable.

The deformation preventing layer 4 can be produced in the following manner: For example, the above-mentioned resin is coated onto one side surface of the light emitting diode sealing layer 2, and the coated resin is cured by heating at, for example, 40 to 150°C, or preferably 50 to 140°C for 1 to 60 minutes, or preferably for 1 to 30 minutes.

The deformation preventing layer 4 has a thickness of, for example, 10 to 300 µm, or preferably 50 to 200 µm.

The deformation preventing layer 4 has a hardness (Shore hardness), which is measured at room temperature with a Shore A durometer, of, for example, A30 to A95, or preferably A50 to A70.

Then, for example, the light emitting diode sealing layer 2 and the deformation preventing layer 4, and the lens mold layer 3 are stuck to each other so that the deformation preventing layer 4 is opposed to the lens mold layer 3, and the stuck layers are heated at, for example, 40 to 150°C, or preferably 50 to 140°C for 1 to 60 minutes, or preferably for 3 to 30 minutes, so that the light emitting diode sealing member 1 can be produced with the light emitting diode sealing layer 2 and the lens mold layer 3 being kept in the B-stage state.

The light emitting diode sealing member 1 has a thickness of, for example, 210 to 2400 µm, or preferably 1000 to 1500 µm.

When the light emitting diodes 13 (described later) are sealed by, for example, compression molding using the light emitting diode sealing member 1, deformation may be produced in the light emitting diode sealing layer 2 and/or the lens mold layer 3 (see FIG. 3(e)).

However, since the light emitting diode sealing member 1 has the deformation preventing layer 4 laminated between the light emitting diode sealing layer 2 and the lens mold layer 3, deformation of the light emitting diode sealing layer 2 and the lens mold layer 3 can be suppressed, as shown in FIG. 5.
FIG. 6 is a schematic configurational diagram illustrating a light emitting diode device using a light emitting diode sealing member according to another embodiment (an embodiment in which, in the light emitting diode sealing member, a light emitting diode sealing layer contains more curing catalysts than a lens mold layer does) of the invention.
In the above description, the light emitting diode sealing layer 2 and the lens mold layer 3 are formed of the same silicone resin (a silicone resin containing a condensation catalyst and an addition reaction catalyst in the same amount). However, for example, both the light emitting diode sealing layer 2 and the lens mold layer 3 are formed of a silicone resin curable with a curing catalyst, and more curing catalysts (addition reaction catalysts) can be contained in the light emitting diode sealing layer 2 than in the lens mold layer 3.
In other words, in this embodiment, the silicone resin that forms the light emitting diode sealing layer 2 contains more curing catalysts than the silicone resin that forms the lens mold layer 3.
Specifically, the curing catalyst content of the light emitting diode sealing layer 2 is, for example, 1.5 times or more, or preferably 3.0 times or more, and usually 10 times or less than that of the lens shaping layer 3 on a mass baisis.
During curing of the light emitting diode sealing member 1, the light emitting diode sealing layer 2 containing more curing catalysts is cured earlier than the lens mold layer 3.
Therefore, with the light emitting diode sealing member 1, without providing the deformation preventing layer 4 as shown in FIG. 6, deformation of the light emitting diode sealing layer 2 and the lens mold layer 3 can be suppressed during sealing of the light emitting diode 13.
Further, in the above description, each of the light emitting diode sealing layer 2 and the lens mold layer 3 is formed in a single-layer structure (one layer). However, for example, the light emitting diode sealing layer 2 can be formed in a multilayer structure (two or more layers), and the lens mold layer 3 can also be formed in a multilayer structure (two or more layers).
The method for forming the light emitting diode sealing layer 2 and/or the lens mold layer 3 in a multilayer structure is not particularly limited. For example, known methods, such as a method of forming a plurality of layers and then sticking them together, are adopted.
FIG. 7 is a schematic configurational diagram illustrating a light emitting diode device using a light emitting diode sealing member according to another embodiment (an embodiment in which, in the light emitting diode sealing member, a light emitting diode sealing layer is formed in a double-layer structure) of the invention.
For example, in the light emitting diode sealing member 1, in the case of forming the light emitting diode sealing layer 2 in a double-layer structure including an upper layer and a lower layer, the light emitting diode device 11 produced using the light emitting diode sealing member 1 has the sealing layer 15 (the light emitting diode sealing layer 2 after curing) formed in a double-layer structure including an upper layer and a lower layer (see FIG. 7).
In such light emitting diode sealing member 1, the light emitting diode sealing layer 2 preferably contains a phosphor as described above. In this case, the phosphor may be contained in at least one layer of the light emitting diode sealing layer 2.
Specifically, when the light emitting diode sealing layer 2 and the sealing layer 15 are formed in a double-layer structure including an upper layer and a lower layer as shown in FIG. 7, a phosphor is contained in the lower layer of the light emitting diode sealing layer 2, but may not be contained in the upper layer of the light emitting diode sealing layer 2.
Further, in such light emitting diode sealing member 1, when more curing catalysts (addition reaction catalysts) are contained in the light emitting diode sealing layer 2 than the lens mold layer 3 as described above, at least one layer of the light emitting diode sealing layer 2 may contain more curing catalysts (addition reaction catalysts) than the lens mold layer 3.
Specifically, when the light emitting diode sealing layer 2 and the sealing layer 15 are formed in a double-layer structure including an upper layer and a lower layer as shown in FIG. 7, more curing catalysts (addition reaction catalysts) may be contained in either or both of the upper layer and the lower layer in the light emitting diode sealing layer 2 than the lens mold layer 3.
Therefore, even with this light emitting diode sealing member 1, as shown in FIG. 7, without providing the deformation preventing layer 4, deformation of the light emitting diode sealing layer 2 and the lens mold layer 3 can be suppressed during sealing of the light emitting diode 13.
Further, though not shown, for example, preheating of the light emitting diode sealing layer 2 alone can suppress deformation of the light emitting diode sealing layer 2 and the lens mold layer 3 during sealing of the light emitting diode 13.
Specifically, prior to arrangement of the light emitting diode sealing member 1 (see FIG. 2(c)) between the substrate 12 and the lens molding die 16, only the light emitting diode sealing layer 2 of the light emitting diode sealing member 1 is preheated, which allows the curing to proceed.
Accordingly, the light emitting diode sealing member 1 having the preheated light emitting diode sealing layer 2 is compression molded so as to be sandwiched between the substrate 12 and the lens molding die 16 as shown in FIG. 3(d), so that without containing more curing catalysts (addition reaction catalysts) in the light emitting diode sealing layer 2 than in the lens mold layer 3, deformation of the light emitting diode sealing layer 2 and the lens mold layer 3 can be suppressed during sealing of the light emitting diode 13.
Moreover, when more curing catalysts (addition reaction catalysts) are contained in the light emitting diode sealing layer 2 than in the lens mold layer 3 and such light emitting diode sealing layer 2 is preheated, deformation of the light emitting diode sealing layer 2 and the lens mold layer 3 can be further suppressed during sealing of the light emitting diode 13.

### EXAMPLES

While in the following, the present invention is described in further detail with reference to Examples, the present invention is not limited to any of them by no means.

### Example 1

### <Production of Light Emitting Diode Sealing Layer>

One hundred grams (8.70 mmol) of polydimethylsiloxane having silanol groups at both ends (polysiloxane having silanol groups at both ends, in which R1 in the formula (1) are all represented by methyl, and the average of n is 155) (manufactured by Shin-Etsu Chemical Co., Ltd., trade name "X-21-5842", average molecular weight: 11500), 0.86 g (5.80 mmol) of vinyltrimetoxysilane (alkenyl group-containing alkoxysilane) (manufactured by Shin-Etsu Chemical Co., Ltd., trade name "KBM-1003"), and 10 mL of 2-propanol (8 parts by mass per 100 parts by mass of the total amounts of polydimethylsiloxane having silanol groups at both ends and vinyltrimetoxysilane) were mixed by stirring.

The molar ratio (SiOH/methoxysilyl group) of the SiOH group of the polydimethylsiloxane having silanol groups at both ends to the methoxysilyl group of the vinyltrimetoxysilane was 1/1.

Next, 0.16 mL (0.17 mmol, 2.0 mol per 100 mol of the polydimethylsiloxane having silanol groups at both ends) of an aqueous tetramethylammonium hydroxide solution (concentration: 10% by mass) as a condensation catalyst was added to the resulting mixture, and the added mixture was stirred at room temperature (25°C) for 2 hours.

Then, 0.75 g of organohydrogensiloxane (in which R5 in the formula (3) are all represented by methyl, the average of a is 10, and the average of b is 10. viscosity at 25°C: 20 mPa·s) (manufactured by Shin-Etsu Chemical Co., Ltd., trade name "KF-9901") and 0.26 mL of a platinum-carbonyl complex solution (platinum concentration: 2% by mass) as an addition reaction catalyst (hydrosilylation catalyst) (35 parts by mass per 100 parts by mass of organohydrogensiloxane, 0.7 parts by mass in terms of platinum) were added to the resulting mixture (oil) to produce a silicone resin composition.

The molar ratio (vinyl group/SiH) of the vinyl group of vinyltrimetoxysilane to the SiH group of organohydrogensiloxane was 1/1.

Thereafter, a phosphor particle (spherical shape, average particle size: 17 µm) composed of Y₃Al₅O₁₂:Ce (YAG:Ce) was added to the silicone resin composition thus obtained in a proportion of 5 parts by mass per 100 parts by mass of the silicone resin composition. Further, a nano silica particle (particle size: 20 nm or less) was added in a proportion of 10 parts by mass per 100 parts by mass of the silicone resin composition. Thus, a silicone resin composition containing the phosphor and the inorganic particle was produced.

The silicone resin composition containing the phosphor and the inorganic particle was then coated to a release paper, and the coated composition was heated at 120°C for 6 minutes, to produce a 350 µm -thick light emitting diode sealing layer in a semi-cured state (a B-stage state).

### <Production of Lens Mold Layer>

A silicone resin composition containing an inorganic particle was produced in the same manner as in the above-mentioned <Production of Light Emitting Diode Sealing Layer> except that the phosphor particle was not added.

The silicone resin composition containing an inorganic particle was then coated to a release paper, and the coated composition was heated at 120°C for 6 minutes, to produce a 750 µm-thick lens mold layer in a semi-cured state (a B-stage state).

### <Production of Light Emitting Diode Sealing Member>

The light emitting diode sealing layer and the lens mold layer both produced above were stuck to each other, and the stuck layers were heated at 120°C for 3 minutes, to thereby produce an 1100 µm-thick light emitting diode sealing member.

In the light emitting diode sealing member, the light emitting diode sealing layer and the lens mold layer were kept in the semi-cured state (the B-stage state).

### <Production of Light Emitting Diode Device>

One hundred blue light-emitting diodes (in a 10x10 arrangement) were mounted on the upper surface of a substrate having wiring formed thereon (see FIG. 2(a)).

A lens molding die having 100 hemispherical recesses formed therein was then prepared (see FIG. 2(b)), and the light emitting diode sealing member obtained above was arranged between the lens molding die and the substrate so that the lens mold layer was opposed to the lens molding die (see FIG. 2(c)).

The light emitting diode sealing member was then sandwiched between the substrate and the lens molding die, and the sandwiched member was compression molded at 0.5 MPa and also heated at 160°C for 5 minutes (see FIG. 3(d)). Thereafter, the lens molding die was removed, and the compression-molded member was heated at 150°C for 1 hour to be completely cured. Then, the cured product was cut into separate pieces, to thereby produce 100 light emitting diode devices (see FIG. 3(e)). This enabled the light emitting diode sealing layer to seal the light emitting diodes, and at the same time, the lens mold layer to form lenses.

### Example 2

### <Production of Light Emitting Diode Sealing Member>

A 350 µm-thick light emitting diode sealing layer was produced in the same manner as in Example 1.

### <Production of Deformation Preventing Layer>

A liquid silicone rubber (manufactured by Asahi Kasei Corporation, trade name "LR7665") was coated onto a surface of the light emitting diode sealing layer obtained above so as to give a thickness of 200 µm, and the coated layer was cured by heating at 120°C for 3 minutes, to thereby produce a 200 µm-thick deformation preventing layer, so that a laminated body of the light emitting diode sealing layer and the deformation preventing layer was formed.

The deformation preventing layer had a Shore hardness, which was measured with a Shore A durometer, of A50.

### <Production of Lens Mold Layer>

A 750 µm-thick lens mold layer was produced in the same manner as in Example 1.

### <Production of Light Emitting Diode Sealing Member>

The above-obtained laminated body of the light emitting diode sealing layer and the deformation preventing layer, and the lens mold layer were stuck to each other so that the deformation preventing layer was opposed to the lens mold layer, and the stuck layers were heated at 120°C for 3 minutes, to thereby produce a 1300 µm-thick light emitting diode sealing member.

In the light emitting diode sealing member, the light emitting diode sealing layer and the lens mold layer were kept in the semi-cured state (the B-stage state).

### <Production of Light Emitting Diode Device>

A light emitting diode device was produced in the same manner as in Example 1 (see FIG. 5).

### Example 3

### <Production of Light Emitting Diode Sealing Layer>

A 350 µm-thick light emitting diode sealing layer in a semi-cured state (a B stage state) was produced in the same manner as in Example 1, except that 0.87 mL of a platinum-carbonyl complex solution (platinum concentration: 2% by mass) as an addition reaction catalyst (hydrosilylation catalyst) (116.7 parts by mass per 100 parts by mass of organohydrogensiloxane, 2.3 parts by mass in terms of platinum (3.3 times larger than the blended amount in Example 1)) was blended.

### <Production of Lens Mold Layer>

A 750 µm-thick lens mold layer was produced in the same manner as in Example 1.

### <Production of Light Emitting Diode Sealing Member>

A 1100µm-thick light emitting diode sealing member was produced in the same manner as in Example 1.

In the light emitting diode sealing member, the light emitting diode sealing layer and the lens mold layer were kept in the semi-cured state (the B stage state).

### <Production of Light Emitting Diode Device>

A light emitting diode device was produced in the same manner as in Example 1 (see FIG. 6).

### Evaluation

In each of Examples, the light emitting diode device was able to be produced easily and accurately in fewer process steps.

In Example 1, an interface between the light emitting diode sealing layer and the lens mold layer was deformed in a curved shape along the shape of the lens (see FIG. 3(e)), but in Examples 2 and 3, deformation was not observed in the interface between the light emitting diode sealing layer and the lens mold layer, which revealed that the light emitting diode device was able to be more accurately produced (see FIGS. 5 and 6).

While the illustrative embodiments of the present invention are provided in the above description, such is for illustrative purpose only and it is not to be construed restrictively. Modification and variation of the present invention that will be obvious to those skilled in the art is to be covered by the following claims.

## Claims

1. A light emitting diode sealing member comprising:
a light emitting diode sealing layer; and
a lens mold layer laminated on the light emitting diode sealing layer.

2. The light emitting diode sealing member according to claim 1, wherein the light emitting diode sealing layer is made of silicone resin containing a phosphor.

3. The light emitting diode sealing member according to claim 1 or 2, wherein the lens mold layer is made of silicone resin.

4. The light emitting diode sealing member according to claim 1, 2 or 3, further comprising a deformation preventing layer between the light emitting diode sealing layer and the lens mold layer.

5. The light emitting diode sealing member according to any of claims 1 to 4, wherein both of the light emitting diode sealing layer and the lens mold layer are made of a silicone resin curable with a curing catalyst, the light emitting diode sealing layer containing more curing catalysts than the lens mold layer does.

6. A method for producing a light emitting diode device comprising the steps of:
preparing a substrate having a light emitting diode mounted thereon;
preparing a lens molding die; and
arranging a light emitting diode sealing member comprising a light emitting diode sealing layer and a lens mold layer laminated on the light emitting diode sealing layer, between the substrate and the lens molding die, so that the lens mold layer is opposed to the lens molding die, and then compression molding the light emitting diode sealing member.
